# EUROPÄISCHE PATENTANMELDUNG

(11) **EP 1 791 177 A1**
(43) Veröffentlichungstag der Anmeldung: **30.05.2007**
(21) Anmeldenummer: 05026032.2
(22) Anmeldetag: 29.11.2005
(51) Int. Cl.: H01L 23/36, H01L 23/367, H01L 23/373, H01L 23/433, H05K 7/20

(54) **Halbleitereinheit mit verbesserter Wärmekopplungsanordnung**

(71) Anmelder: Congatec AG, 94469 Deggendorf (DE)
(72) Erfinder: Gerhard Edi, 94469 Deggendorf (DE)
(74) Vertreter: Grünecker, Kinkeldey, Stockmair & Schwanhäusser Anwaltssozietät

(57) **Zusammenfassung**

Die vorliegende Erfindung betrifft eine Halbleitereinheit für die Verwendung in "computer on modules" (CoM). Die Halbleitereinheit umfasst einen Prozessorkern auf einem Chip, der wiederum elektrisch mit einer Leiterplatte verbunden ist und einen Hitzeverteiler, der thermisch über eine Wärmekopplungsanordnung mit dem Chip verbunden ist. Die Wärmeabfuhr vom Chip weg, erfolgt über die Wärmekopplungsanordnung zum Hitzeverteiler, der mit einer optionalen Systemkühllösung verbunden werden kann. Um die Austauschbarkeit und die Anbindung an eine Basisplatine zu gewährleisten, muss die Halbleitereinheit in ihren Abmessungen genau spezifiziert sein. Toleranzen der Bauteile und des Lötprozesses können mechanische Belastungen verursachen, was zu Schäden an Chip oder Leiterplatte führen kann. Die Wärmekopplungsanordnung umfasst erfindungsgemäß ein flexibles Wärmekopplungselement, das den Toleranzausgleich durchführt. Dieses flexible Wärmekopplungselement kann als elastische Schicht oder als federnder Teil des Hitzeverteilers ausgeführt werden. Des weiteren weist der Hitzeverteiler im Kontaktbereich zur elastischen Schicht mehrere Vertiefungen auf, welche die Kontaktfläche vergrößern.

## Beschreibung

### TECHNISCHES FELD

Die vorliegende Erfindung betrifft im Allgemeinen Halbleitereinheiten. Im Speziellen befasst sich die vorliegende Erfindung mit einer Halbleitereinheit, die neben der verbesserten Wärmekopplung zwischen einem Chip und einem Hitzeverteiler auch eine flexible Kopplungsanordnung aufweist, die Toleranzen der Bauteile und des Montageprozesses ausgleichen kann.

### HINTERGRUND

Halbleitereinheiten werden beispielsweise auf Leiterplatten montiert, auf denen zusätzlich weitere Bauteile angebracht sind, die je nach Funktionalität der Leiterplatten variieren. Die Erfindung kann auch in solchen Gebieten Anwendung finden, da sie zum einem der Wärmeabfuhr dient, aber auch Toleranzen ausgleicht, wobei Toleranzen bei nahezu allen Montageprozessen auftreten. Der Ausgleich der Toleranzen ist besonders bei solchen Halbleiterbaugruppen wichtig, die in sogenannte Basisplatinen eingebaut werden. Solche Baugruppen werden "Computer on Modules" CoM-Lösungen genannt.

CoM-Lösungen sind hoch integrierte CPU-Module. Sie stellen zwar keine selbständig lauffähigen Computer dar, enthalten aber die wichtigsten Funktionselemente eines Computers. Erst durch den Einbau der Module in eine Basisplatine erhalten sie ihre Funktionalität, wie beispielsweise als Messgerät, Steuercomputer oder für eine andere Applikation. Die Systemerweiterung und -anpassung wird also ausschließlich über die Basisplatinen ermöglicht, wodurch eine teilweise kundenspezifische integrierte Lösung entsteht. Die Basisplatinen enthalten alle erforderlichen Anschlüsse um das System an Peripheriegeräte wie Festplatten, Maus oder Bildschirm anzuschließen. Die CoM-Module enthalten beispielsweise den Prozessor, Prozessorbus und Speicher (RAM), können, je nach Hersteller, aber auch eine kleine Anzahl von Standard-Peripheriefunktionen übernehmen. CoM-Module können entweder als Steckkarten in eine Basisplatine eingebaut werden oder flach über entsprechende Verbinder mit der Basisplatine verbunden werden.

CoM-Module haben üblicherweise ein spezifiziertes Interface zur Anbindung an geeignete Kühllösungen. Dieses Interface wird im weiteren Hitzeverteiler (engl. = heat spreader) genannt, wobei allerdings auch andere Bezeichnungen geläufig sind, wie Wärmespreizplatte, Wärmeverteiler oder auch Kühlkörper. Der Hitzeverteiler wird dazu verwendet, im CoM-Modul eine Wärmeabfuhr von den aktiven, hitzeerzeugenden Bauteilen, wie CPU oder Chip, zu ermöglichen.

Eine große Stärke von CoM-Modulen ist deren freie Austauschbarkeit. Die thermische Anbindung des Moduls an eine weitere Kühllösung erfolgt somit immer über die Hitzeverteileroberfläche an der gleichen geometrischen Position. Um eine Austauschbarkeit innerhalb der Systemumgebung ohne mechanische Anpassungen zu gewährleisten, müssen die CoM-Module daher in ihren Abmessungen, wie Höhe, Breite und Länge genau spezifiziert sein.

Toleranzen der Bauteile und Sollabweichungen während des Montageprozesses, beispielsweise durch den Lötprozess, erschweren die positionsgenaue Anbindung zur Basisplatine und zur Systemkühllösung. Bei ungünstigen Toleranzen entstehen unerwünschte mechanische Belastungen an dem Schaltungsträger, beispielsweise einer Leiterplatte, und dem Hitzeverteiler, was zu einer Durchbiegung der Leiterplatte führen kann.

Die Aufgabe, die der vorliegenden Erfindung zugrunde liegt, besteht darin, eine verbesserte Wärmeableitung von den hitzeerzeugenden Bauteilen, wie CPU oder Chipsatz, zum Hitzeverteiler zu ermöglichen, wobei der Hitzeverteiler kostengünstig fertigbar sein soll. Eine weitere Aufgabe, die der vorliegenden Erfindung zugrunde liegt, besteht darin, eine positionsgenaue Anbindung des CoM-Moduls an die Systemkühllösung bei möglichst geringen mechanischen Belastungen zu gewährleisten.

### ZUSAMMENFASSUNG DER ERFINDUNG

Diese Aufgaben werden erfindungsgemäß durch eine Halbleitereinheit mit den Merkmalen der unabhängigen Patentansprüche gelöst.

Entsprechend der vorliegenden Erfindung ist eine Halbleitereinheit vorgesehen, wobei diese umfasst: eine Leiterplatte mit einander gegenüberliegenden ersten und zweiten Oberflächen; einen Chip mit einander gegenüberliegenden aktiven und rückseitigen Flächen, wobei die rückseitige Fläche des Chips auf der ersten Oberfläche der Leiterplatte montiert ist; einen Hitzeverteiler, der mit dem Chip wärmeleitend verbunden ist und an der Leiterplatte befestigt ist; eine thermisch leitfähige Wärmekopplungsanordnung mit mindestens einem thermisch leitfähigen Wärmekopplungselement, die thermisch mit dem Chip zum Abführen von Verlustwärme verbunden ist, und wobei mindestens ein Wärmekopplungselement flexibel ausgeführt ist.

Gemäß einer vorteilhaften Ausführungsform ist der Hitzeverteiler mit der Leiterplatte lösbar verbunden. Dies hat den Vorteil, dass der Hitzeverteiler austauschbar ist. Des weiteren werden durch die Demontierbarkeit des Hitzeverteilers Reparaturarbeiten am CoM-Modul erleichtert. Es ist aber ersichtlich, dass die erfindungsgemäße Lösung auch für Hitzeverteiler anwendbar ist, die nicht lösbar mit einer Leiterplatte verbunden sind.

Gemäß einer weiteren vorteilhaften Ausführungsform ist die thermisch leitfähige Wärmekopplungsanordnung über Wärmeleitpaste mit dem Chip thermisch verbunden. Dies verbessert die thermische Anbindung des hitzeerzeugenden Chips an die Wärmekopplungsanordnung.

Gemäß einer weiteren vorteilhaften Ausführungsform ist der Chip als oberflächenmontierbares Bauteil ausgeführt. Ein wichtiger Vorteil dieser Montagetechnik ist, dass kleinere Bauteilabmessungen möglich sind. Weitere Vorteile sind, dass eine einfache und sehr schnelle Automatenbestückung möglich ist und dass dabei keine Löcher in die Leiterplatine gebohrt werden müssen. Es ist aber klar, dass die erfindungsgemäßen Prinzipien auch für beliebige andere Montagetechniken anwendbar sind.

Gemäß einer weiteren vorteilhaften Ausführungsform ist der Hitzeverteiler zum Abführen der Wärme mit einem Kühlkörper verbindbar, der vorzugsweise an der vom Chip abgewandten Seite des Hitzeverteilers anliegt. Dadurch wird eine verbesserte Wärmeableitung ermöglicht, da der Kühlkörper die Hitze vom Hitzeverteiler abführt.

Gemäß einer weiteren vorteilhaften Ausführungsform besteht die thermisch leitfähige Wärmekopplungsanordnung aus einem mehrschichtigen wärmeleitenden Block, der zwischen der aktiven Fläche des Chips und dem Hitzeverteiler angebracht ist, wobei das flexible Wärmekopplungselement durch mindestens eine elastische Schicht gebildet ist. Ein solcher Block ist einfach zu fertigen und leicht zwischen Hitzeverteiler und Chip zu montieren.

Gemäß einer weiteren vorteilhaften Ausführungsform besteht die elastische Schicht des flexiblen Wärmekopplungselements aus einem graphitgefüllten Silikonmaterial. Dieses Material ist elastisch und besitzt gleichzeitig gute thermische Eigenschaften.

Gemäß einer weiteren vorteilhaften Ausführungsform enthält die thermisch leitfähige Wärmekopplungsanordnung ein wärmeleitendes Wärmekopplungselement aus Kupfer, das an der aktiven Fläche des Chips anliegt. Kupfer besitzt sehr gute Wärmeleitungseigenschaften und leitet somit die Wärme effizient vom Chip weg.

Gemäß einer weiteren vorteilhaften Ausführungsform weist der Hitzeverteiler in dem Flächenbereich, der mit der thermisch leitfähigen Wärmekopplungsanordnung in Anlage ist, mindestens eine Vertiefung auf, und des weiteren liegt das flexible Wärmekopplungselement an dem vertieften Hitzeverteilerflächenbereich an. Durch die Vertiefung des Hitzeverteilers und die Verbindung mit dem flexiblem Wärmekopplungselement wird die Kontaktoberfläche vergrößert, was zu einem verbesserten Wärmeaustausch führt.

Gemäß einer weiteren vorteilhaften Ausführungsform enthält die thermisch leitfähige Wärmekopplungsanordnung ein Wärmekopplungselement, das in dem Flächenbereich, der mit dem flexiblen Wärmekopplungselement in Anlage ist, mindestens eine Vertiefung aufweist. Durch die Vertiefung des Wärmekopplungselement wird die Kontaktfläche zu dem flexiblen Wärmekopplungselement vergrößert, was zu einem verbesserten Wärmeaustausch führt.

Gemäß einer weiteren vorteilhaften Ausführungsform enthält die thermisch leitfähige Wärmekopplungsanordnung ein Wärmekopplungselement, das in dem Flächenbereich, der mit dem flexiblen Wärmekopplungselement in Anlage ist, mindestens eine Erhöhung aufweist. Auch hier ist die Kontaktfläche durch die Erhöhung vergrößert und damit der Wärmeaustausch verbessert.

Gemäß einer weiteren vorteilhaften Ausführungsform ist das flexible Wärmekopplungselement ein federnder Teil des Hitzeverteilers. Der Hitzeverteiler selbst kann zum Toleranzausgleich verwendet werden, kein zusätzliches Bauteil muss flexibel ausgeführt werden.

Gemäß einer weiteren vorteilhaften Ausführungsform ist der federnde Teil des Hitzeverteilers durch eine teilweise freigeschnittene Zunge gebildet. Das flexible Wärmekopplungselement ist somit näher am hitzeerzeugenden Chip und kann deshalb die Hitze besser abführen.

Gemäß einer weiteren vorteilhaften Ausführungsform weist die freigeschnittene Zunge in einem Verbindungsbereich zum Hitzeverteiler einen abgewinkelten Bereich auf. Dadurch wird die Flexibilität der Zunge erhöht und es kann sichergestellt werden, dass der mit dem Chip in Kontakt stehende Bereich der Zunge im Wesentlichen parallel zu der Oberfläche verläuft und somit einen optimalen Wärmeübergang ermöglicht.

Gemäß einer vorteilhaften Ausführungsform, weist die thermisch leitfähige Wärmekopplungsanordnung ein Wärmekopplungselement aus Kupfer auf, das zwischen der aktiven Fläche des Chips und dem federnden Teil des Hitzeverteilers angebracht ist. Die guten Wärmeleiteigenschaften des Kupfers verbessern den Wärmeaustausch.

Gemäß einer weiteren vorteilhaften Ausführungsform weist die thermisch leitfähige Wärmekopplungsanordnung ein elastisches Wärmekopplungselement auf, das an dem federnden Teil des Hitzeverteilers anliegt. Ein solches weiteres elastisches Element verbessert den Toleranzausgleich und verringert so auftretende mechanische Belastungen insbesondere bei thermischer Beanspruchung.

Gemäß einer weiteren vorteilhaften Ausführungsform weist der federnde Teil des Hitzeverteilers in dem Flächenbereich, der mit dem elastischen Wärmekopplungselement in Anlage ist, mindestens eine Vertiefung auf. Die Vertiefung erhöht die Kontaktfläche und verbessert damit den Wärmeaustausch.

### KURZE BESCHREIBUNG DER FIGUREN

Anhand der in den beiliegenden Zeichnungen dargestellten vorteilhaften Ausgestaltungen wird die Erfindung im Folgenden näher erläutert. Ähnliche oder korrespondierende Einzelheiten des erfindungsgemäßen Gegenstandes sind mit denselben Bezugszeichen versehen. Es zeigen:
- Figur 1: eine schematische Schnittdarstellung einer Halbleitereinheit nach einer Ausführungsform;
- Figur 2: eine schematische Schnittdarstellung einer Halbleitereinheit nach einer weiteren Ausführungsform;

- Figur 3: eine schematische Schnittdarstellung einer Halbleitereinheit nach einer weiteren Ausführungsform;
- Figur 4: eine schematische Schnittdarstellung einer Halbleitereinheit nach einer weiteren Ausführungsform;
- Figur 5: eine Draufsicht einer Halbleitereinheit nach einer weiteren Ausführungsform;
- Figur 6: zeigt eine schematische Schnittdarstellung der Halbleitereinheit der Ausführungsform aus Figur 5;
- Figur 7: eine Draufsicht einer Halbleitereinheit nach einer weiteren Ausführungsform;
- Figur 8: eine schematische Schnittdarstellung der Halbleitereinheit der Ausführungsform aus Figur 7;
- Figur 9: eine Draufsicht einer Halbleitereinheit nach einer weiteren Ausführungsform;
- Figur 10: eine schematische Schnittdarstellung der Halbleitereinheit der Ausführungsform aus Figur 8.

### AUSFÜHRLICHE BESCHREIBUNG DER FIGUREN

Die dargestellten Ausführungsformen sind als Anschauungsbeispiele anzusehen und nicht als Einschränkungen der Erfindung.

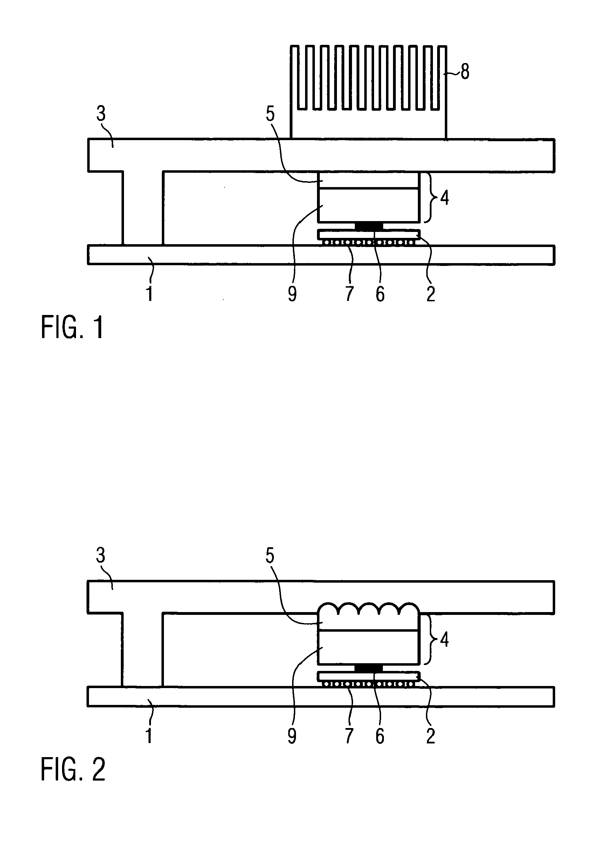

Figur 1 zeigt eine Schnittdarstellung einer Halbleitereinheit nach einer Ausführungsform der vorliegenden Erfindung. Die Halbleitereinheit der Figur 1 wird üblicherweise in eine Basisplatine eingebaut um eine anwendungsspezifische integrierte Lösung zu erzielen.

Ein Chip 2 mit einer aktiven und einer rückseitigen Fläche stellt hier den ausführenden Teil des CPU-Moduls dar, wobei die aktive Fläche des Chips 2 einen Prozessorkern 6 umfasst. Die rückseitige Fläche des Chips 2 ist auf einer Leiterplatte 1 montiert. Es können beispielsweise Lötkügelchen 7 verwendet werden, um den Chip elektrisch und fest mit der Leiterplatte zu verbinden. Der Chip 2 kann beispielsweise als oberflächenmontiertes (engl.= surface mounted device) Bauteil ausgeführt sein. Die "surface mount technology" SMT wird heute üblicherweise verwendet, da sie gegenüber früheren Verfahren zahlreiche Vorteile bietet. Das dabei verwendete Wiederaufschmelzlöten ist ein Weichlötverfahren, bei dem die Bauteile durch Weichlot und Lötpaste direkt auf einer Leiterplatte montiert werden. Allerdings sind darüber hinaus alle dem Fachmann geläufigen Techniken zur Montage eines Chips auf einer Leiterplatte möglich.

Während des Betriebs des CoM-Moduls entsteht an dem Chip Hitze, die von dem Chip 2, inklusive Prozessorkern 6 abgeführt werden muss, um eventuelle Hitzeschäden an der Leiterplatte 1 und dem Chip 2 zu vermeiden. Ein Hitzeverteiler 3 ist über dem Chip 2 montiert und führt zum einen die Wärme vom Chip 2 ab und schützt zum anderen den Chip 2 vor möglichen Beschädigungen. Der Hitzeverteiler 3 ist mit der Leiterplatte lösbar verbunden.

Beispielsweise kann der Hitzeverteiler 3 durch entsprechende Befestigungsvorrichtungen mit Schrauben (nicht gezeigt) an die Leiterplatte montiert werden. Allerdings sind alle dem Fachmann geläufigen Montagemöglichkeiten, die eine lösbare Befestigung erlauben, ebenfalls denkbar. Darunter fallen beispielsweise auch Nieten-, Klammer- oder Klebebefestigungen (ebenfalls nicht gezeigt). Eine solche lösbare Montage hat den Vorteil, dass der Hitzeverteiler 3 ausgetauscht werden kann. Weiterhin kann für Reparaturarbeiten am Chip 2 der Hitzeverteiler 3 demontiert werden, wodurch der Chip 2 leichter erreichbar ist.

Um den Chip 2 thermisch an den Hitzeverteiler 3 anzubinden, wird eine thermisch leitfähige Wärmekopplungsanordnung 4 verwendet. Diese ist in Figur 1 zwischen der aktiven Fläche des Chips 2 und dem Hitzeverteiler 3 angeordnet, so dass eine direkte thermische Verbindung des hitzerzeugenden Chips 2 mit dem Hitzeverteiler 3 hergestellt wird.

Die Halbleitereinheit wird als standardisierte Einheit in eine Basisplatine eingebaut und üblicherweise mit weiteren Kühllösungen des Systems verbunden. Eine solche Kühllösung ist in Figur 1 beispielhaft als eine Vielzahl von Kühlrippen 8 veranschaulicht. Andere Kühllösungen sind aber ebenfalls möglich. Dabei können alle dem Fachmann geläufigen Kühlkörper und Kühlprozesse Anwendung finden, wie beispielsweise eine Lüfter- oder Wasserkühlung. Weiters ist auch eine Wärmeabfuhr mittels Heatpipe denkbar. Auch die Größe der Kontaktfläche zum Hitzeverteiler 3 ist je nach Systemumgebung geeignet zu wählen. Vorzugsweise liegt der Kühlkörper 8 an den vom Chip 2 abgewandten Seiten des Hitzeverteilers 3 an. Für die Funktion der vorliegenden Erfindung ist die verwendete Systemkühllösung 8 ohne große Bedeutung.

Eine standardisierte Anbindung an das System (Kühllösung, Basisplatine) erfordert genau spezifizierte Abmessungen der Halbleitereinheit. Bauteile werden zwar möglichst maßgenau gebaut, sind aber trotzdem gewissen Toleranzschwankungen unterworfen. Üblicherweise bewegen sich diese Toleranzen im Bereich von ± 0.2 mm. Darüber hinaus entstehen beispielsweise bei der Montage des Chips 2 auf der Leiterplatte 1 durch den Lötprozess Toleranzen. Diese Bau- und Montagetoleranzen erschweren zum einem die Anbindung an die Basisplatine, aber zum anderen auch die Montage der Halbleitereinheit.

Bei ungünstigen Toleranzkombinationen der Bauteile kann es zu mechanischen Belastungen kommen, die zu einer Durchbiegung der Leiterplatte 1 führen. Beispielsweise können große mechanische Belastungen bei großen positiven Toleranzen des Lötprozesses und/oder der Bauteile und bei einer nicht erfindungsgemäßen Wärmeanbindung an den Hitzeverteiler 3 auftreten. Bei der Anbindung an die Kühllösung 8 des Systems, hier beispielhaft eine Kühlrippe an derselben mechanischen Position, wird eine mechanische Kraft über den Hitzeverteiler 3 und die nicht erfindungsgemäße Wärmeanbindung auf den Chip 2 und damit auf die Leiterplatte 1 ausgeübt. Durch die mechanische Belastung wird die Leiterplatte 1 durchbogen, wobei dies durchaus zu Schäden führen kann.

Falls eine große negative Toleranz des Lötprozesses auftritt, so wird zwar keine mechanische Kraft auf die Leiterplatte ausgeübt, allerdings ist eine optimale Wärmeanbindung des Chips an die Systemkühllösung nicht gewährleistet. Es können Lücken zwischen der nicht erfindungsgemäßen Wärmeanbindung und dem Hitzeverteiler auftreten, welche die Wärmeabfuhr verschlechtern.

In einer Ausführungsform besteht die Wärmekopplungsanordnung 4 aus einem mehrschichtigen wärmeleitenden Block 4. Dabei umfasst die Wärmekopplungsanordnung erfindungsgemäß eine elastische Schicht 5. Diese elastische Schicht 5 ermöglicht einen Toleranzausgleich. Die mechanischen Belastungen die, wie oben erläutert, bei ungünstigen Toleranzen der Bauteile und des Lötprozesses auftreten können, werden von der elastischen Schicht 5 kompensiert. Die mechanische Kraft sorgt für eine Kompression der elastischen Schicht. Daher erfolgt keine Übertragung der Kraft auf die Leiterplatte 1 und somit auch keine Durchbiegung der Leiterplatte 1.

Da die elastische Schicht 5 komprimierbar ist, kann diese so ausgeführt sein, dass sie stets etwas dicker als nötig ist. Dadurch erfolgt immer eine lückenlose und damit uneingeschränkte Wärmeanbindung an den Hitzeverteiler 3, auch wenn, wie oben erläutert negative Toleranzen auftreten. In diesem Fall würde die elastische Schicht 5 weniger komprimiert werden als bei positiven Toleranzen des Lötprozesses und der Bauteile.

Die elastische Schicht 5 sollte eine möglichst große Fläche zum Hitzeverteiler 3 aufweisen und möglichst dünn sein, da die elastische Schicht 5 normalerweise eine schlechtere thermische Leitfähigkeit aufweist. Allerdings ist die Schicht bei abnehmender Dicke weniger elastisch und flexibel, wodurch eine größere Kraft nötig wäre, um Toleranzen auszugleichen. Deswegen muss ein Kompromiss zwischen thermischer Leitfähigkeit und Flexibilität gefunden werden.

Die elastische Schicht 5 kann dabei aus verschiedenen Materialien bestehen, solange diese gute Wärmeleiteigenschaften haben und ausreichend elastisch sind. Beispielhaft seien hier graphitgefüllte Silikone erwähnt. Jedoch können andere, dem Fachmann geläufige Materialien verwendet werden, die elastisch sind.

Zur besseren thermischen Anbindung der Wärmekopplungsanordnung 4 kann diese über eine dünne Schicht Wärmeleitpaste (nicht gezeigt), die einen geringen thermischen Übergangswiderstand besitzt, mit den Chip 2 verbunden werden.

Weiterhin ist es vorteilhaft, dass eine Schicht 9 des wärmeleitenden Blockes 4 aus Kupfer oder ähnlich gut wärmeleitenden Material besteht. Die Menge an thermischer Energie, welche die Kupferschicht aufnehmen kann, hängt von ihrem Volumen ab. Die Kupferschicht 9 liegt entweder direkt oder über eine dünne Schicht Wärmeleitpaste am Chip 2, beziehungsweise am Prozessorkern 6 an und nimmt dessen Hitze auf und gibt diese an weitere Schichten des wärmeleitenden Blockes 4 ab, in Figur 1 an die elastische Schicht 5. Diese wiederum gibt die Hitze an den Hitzeverteiler 3 weiter, der mit einer weiteren Kühltechnik 8 des System gekühlt wird.

Figur 2 zeigt eine schematische Schnittdarstellung einer Halbleitereinheit gemäß einer weiteren Ausführungsform. Der Aufbau des Figur 2 ähnelt weitestgehend dem aus Figur 1. Deswegen soll hier hauptsächlich auf die Erläuterungen in Bezug zu Figur 1 hingewiesen werden. Auch in dieser Ausführungsform ist der Chip 2 mit Prozessorkern 6 auf einer Leiterplatte 1 montiert. Ein Hitzeverteiler 3 ist über dem Chip 2 und an der Leiterplatte 1 lösbar montiert. Die thermisch leitfähige Wärmekopplungsanordnung 4 verbindet den Chip 2 und den Hitzeverteiler 3 und führt so die Wärme ab. Des weiteren ist die Wärmekopplungsanordnung 4 als Block ausgeführt, der eine elastische Schicht 5 umfasst.

Der Hitzeverteiler weist in dem Flächenbereich, der mit der elastischen Schicht in Anlage ist, mehrere Vertiefungen auf. Diese Vertiefungen können während des Ausstanzens des Hitzeverteilers geprägt werden, was zu einer sehr kostengünstigen Fertigung führt. Allerdings können andere, für den Fachmann bekannte und übliche Methoden verwendet werden, um diese Vertiefungen zu erzielen.

Durch die Vertiefungen wird die Kontaktfläche zwischen dem Hitzeverteiler 3 und der Wärmekopplungsanordnung, hier dem Block 4, vergrößert, was zu einem verbesserten thermischen Übergang führt. Weiterhin wird der Toleranzausgleich bei gleicher Anpresskraft verbessert. Die elastische Schicht 5 muss die Vertiefungen des Hitzeverteilers 3 nicht vollständig ausfüllen, da die Kontaktfläche durch die Prägung schon vergrößert wird und die elastische Schicht 5 an Teilstellen stärker komprimiert wird, wodurch ein geringerer Wärmewiderstand entsteht.

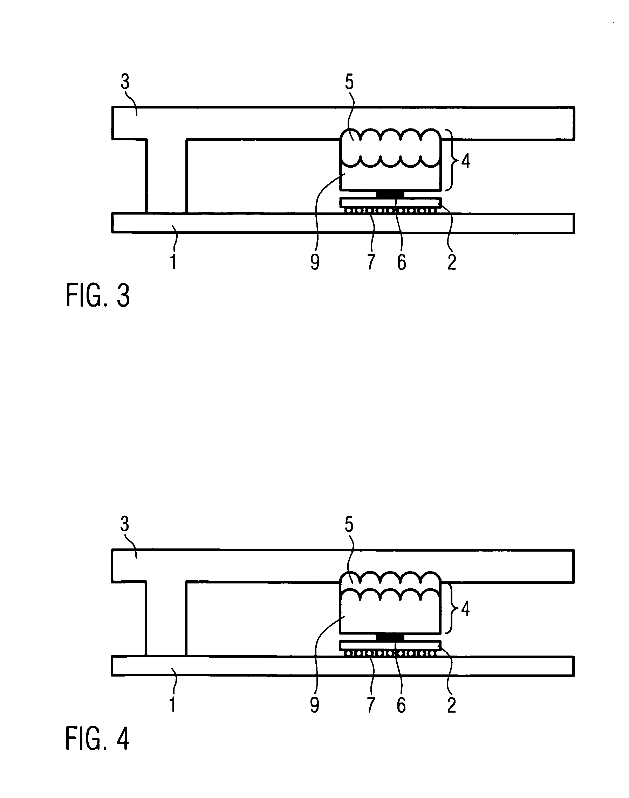

Figur 3 zeigt eine schematische Schnittdarstellung einer Halbleitereinheit gemäß einer weiteren Ausführungsform. Im Allgemeinen ähnelt der Aufbau der Halbleitereinheit aus Figur 3 denen aus den Figuren 1 und 2. Folglich werden hier nur die Unterschiede zu den vorhergehenden Ausführungsformen erläutert.

Die thermisch leitfähige Wärmekopplungsanordnung 4 zum thermischen Verbinden des Chips 2 an den Hitzeverteiler 3 ist wiederum ein Block, umfassend eine elastische Schicht 5. Der Hitzeverteiler 3 weist die Prägung auf, die oben schon mit Bezug auf Figur 2 erläutert wurde. Des weiteren umfasst der Block 4 eine metallene Schicht 9, die direkt oder über eine dünne Schicht Wärmeleitpaste mit dem Prozessorkern 6 verbunden ist. Die metallene Schicht 9 weist an der Kontaktfläche, die mit dem elastischen Wärmekopplungselement 5 in Anlage ist, mehrere Vertiefungen auf. Analog zu den Erläuterungen für die Prägung des Hitzeverteilers aus Figur 2 wird dadurch die Kontaktfläche zwischen der metallenen und der elastischen Schicht vergrößert und damit die Wärmeabfuhr und der Toleranzausgleich verbessert.

Figur 4 zeigt eine schematische Schnittdarstellung einer Halbleitereinheit nach einer weiteren Ausführungsform, bei der die metallene Schicht 9 anstatt der Vertiefungen aus Figur 3 mehrere Erhöhungen aufweist. Dadurch wird die Kontaktfläche zwischen der metallenen 9 und der elastischen Schicht 5 vergrößert und damit die Wärmeabfuhr und der Toleranzausgleich verbessert.

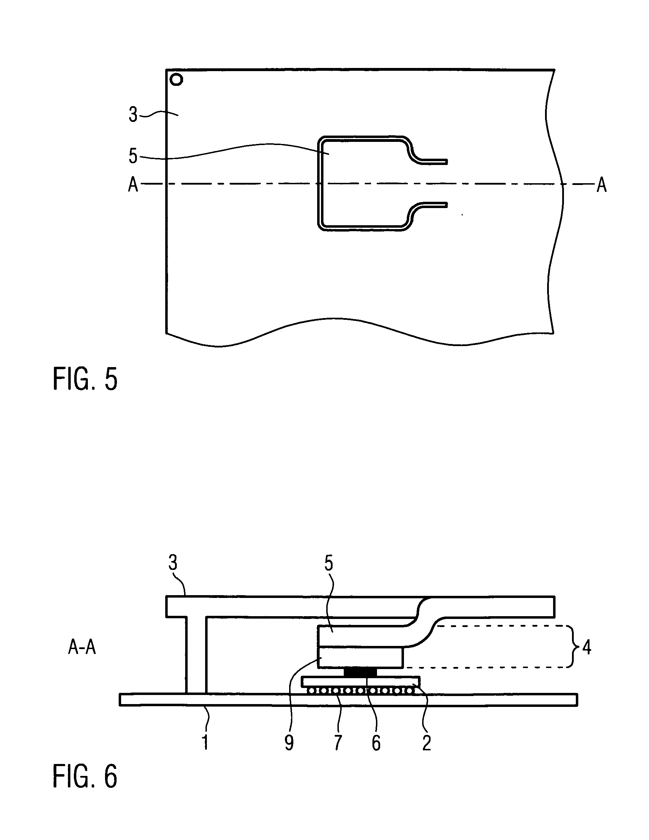

Figur 5 und Figur 6 zeigen eine schematische Draufsicht bzw. eine Schnittdarstellung einer Halbleitereinheit nach einer weiteren Ausführungsform. Das flexible Wärmekopplungselement 5 der Wärmekopplungsanordnung 4 ist hier ein federnder Teil des Hitzeverteilers 3.

Figur 5 zeigt die Draufsicht des Hitzeverteilers 3 mit dem federnden Teil 5. Der federnde Teil 5 ist in dieser Ausführungsform an drei Seiten nicht mit dem Hitzeverteiler verbunden. Die federnde Wirkung entsteht durch die Verbindung an einer Seite des federnden Teils 5 mit dem Hitzeverteiler 3. Dabei ist vor allem entscheidend, dass eine federnde Wirkung eines Hitzeverteilerteiles erreicht wird. Somit sind weitere einem Fachmann bekannte Möglichkeiten, um dies zu erreichen, denkbar. Der federnde Teil 5 kann beispielsweise ausgestanzt werden, um die gewünschte Form zu erhalten.

Figur 6 zeigt die schematische Schnittdarstellung in der Schnittebene A, wie sie in Figur 5 angedeutet ist. Hieraus wird erkennbar, dass der federnde Teil 5 des Hitzeverteilers 3 in Richtung des Chips 2 so gebogen ist, dass er im Verbindungsbereich zum Hitzeverteiler einen abgewinkelten Bereich aufweist. Um die gebogen Form zu erhalten, wird beispielsweise der ausgestanzte Bereich tiefgeprägt. Somit ist der federnde Teil 5 ähnlich einer Zunge ausgebildet, die einen abgewinkelten Bereich besitzt, wobei allerdings der größere Bereich parallel zum Hitzeverteiler 3 ist und an der Wärmekopplungsanordnung 4 anliegt. Keine mechanischen Kräfte werden auf die Leiterplatte übertragen, da speziell bei Toleranzen durch den Lötprozess der federnde Teil 5 des Hitzeverteilers 3 diese ausgleichen kann.

Die Wärmekopplungsanordnung 4 umfasst weiterhin eine Schicht 9, die sich zwischen dem Chip 2 und dem federnden Teil 5 des Hitzeverteilers 3 befindet. Diese ermöglicht einen direkten thermischen Energieaustausch mit dem Hitzeverteiler 3. Zusätzlich kann eine weitere Kühllösung an den Hitzeverteiler 3 anliegend montiert werden (nicht gezeigt), wobei die Kühllösung eine größere Kontaktoberfläche als die des federnden Teils 5 des Hitzeverteilers 3 haben sollte.

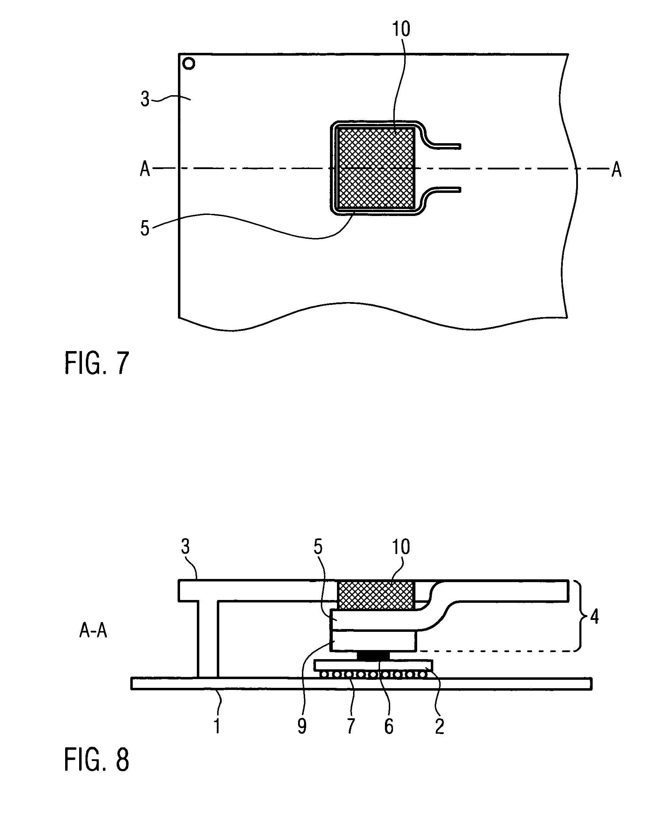

Figur 7 und Figur 8 zeigen eine schematische Draufsicht bzw. eine Schnittdarstellung einer Halbleitereinheit nach einer weiteren Ausführungsform. Im Vergleich zu der Ausführungsform aus Figur 5 und 6 weist die Wärmekopplungsanordnung 4 zusätzlich ein elastisches Wärmekopplungselement 10 auf, das auf der vom Chip abgewandten Seite des federnden Teils 5 des Hitzeverteilers 3 anliegt. Dies verbessert den Wärmeaustausch erheblich, da nun auch eine direkte Verbindung zur Systemkühllösung vorhanden ist. Der Toleranzausgleich bleibt durch die elastische Schicht erhalten, da die bei der Anbindung zur Systemkühllösung auftretenden mechanischen Kräfte durch die Verformung des elastischen Kopplungselements 10 kompensiert werden.

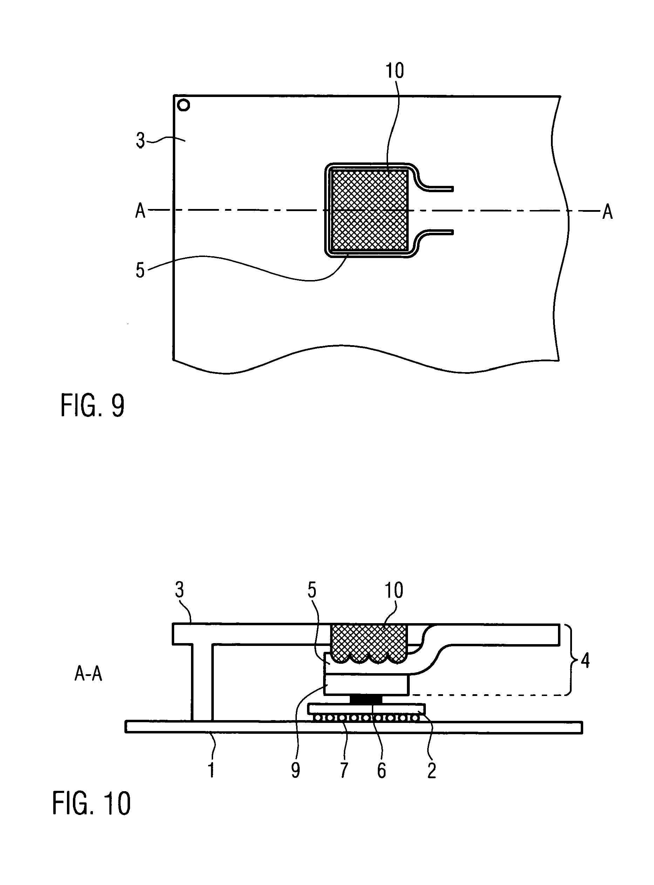

Figur 9 und Figur 10 zeigen eine schematische Draufsicht bzw. eine Schnittdarstellung einer Halbleitereinheit nach einer weiteren Ausführungsform. Wie in Figur 7 und 8 erläutert, ist der federnde Teil 5 des Hitzeverteilers 3 über ein elastisches Wärmekopplungselement 10 mit der Systemkühllösung verbunden. Der federnde Teil 5 des Hitzeverteilers 3 weist in dem Flächenbereich, der mit der elastischen Schicht 10 in Berührung ist, mehrere Vertiefungen auf. Dadurch wird die Kontaktfläche zwischen Hitzeverteiler 3 und elastischen Kopplungselement 10 größer, was zu einer verbesserten Wärmeabfuhr und einem verbesserten Toleranzausgleich führt. Die Vertiefungen können während des Ausstanzens des Hitzeverteilers 3 geprägt werden, wodurch eine kostengünstige Fertigung gewährleistet wird.

## Patentansprüche

1. Eine Halbleitereinheit umfassend:
eine Leiterplatte (1) mit einander gegenüberliegenden ersten und zweiten Oberflächen;
einen Chip (2) mit einander gegenüberliegenden aktiven und rückseitigen Flächen, wobei die rückseitige Fläche des Chips auf der ersten Oberfläche der Leiterplatte montiert ist;
einen Hitzeverteiler (3), der mit dem Chip wärmeleitend verbunden ist und an der Leiterplatte befestigt ist;
eine thermisch leitfähige Wärmekopplungsanordnung (4) mit mindestens einem thermisch leitfähigem Wärmekopplungselement, die thermisch mit dem Chip zum Abführen von Verlustwärme verbunden ist,
wobei mindestens ein Wärmekopplungselement (5) flexibel ausgeführt ist.

2. Die Halbleitereinheit nach Anspruch 1, wobei der Hitzeverteiler (3) mit der Leiterplatte (1) lösbar verbunden ist.

3. Die Halbleitereinheit nach einem der Ansprüche 1-2, wobei die thermisch leitfähige Wärmekopplungsanordnung (4) über Wärmeleitpaste mit dem Chip (2) thermisch verbunden ist.

4. Die Halbleitereinheit nach einem der Ansprüche 1-3, wobei der Chip (2) als oberflächenmontierbares Bauteil ausgeführt ist.

5. Die Halbleitereinheit nach einem der Ansprüche 1-4, wobei der Hitzeverteiler (3) zum Abführen der Wärme mit einem Kühlkörper (8) verbindbar ist, der vorzugsweise an der vom Chip (2) abgewandten Seite des Hitzeverteilers (3) anliegt.

6. Die Halbleitereinheit nach einem der Ansprüche 1-5, wobei die thermisch leitfähige Wärmekopplungsanordnung (4) aus einem mehrschichtigen wärmeleitenden Block (4) besteht, der zwischen der aktiven Fläche des Chips (2) und dem Hitzeverteiler (3) angebracht ist, und
wobei das flexible Wärmekopplungselement durch mindestens eine elastische Schicht (5) gebildet ist.

7. Die Halbleitereinheit nach Anspruch 6, wobei die elastische Schicht (5) des flexiblen Wärmekopplungselements (4) aus einem graphitgefüllte Silikonmaterial besteht.

8. Die Halbleitereinheit nach einem der Ansprüche 1-7, wobei die thermisch leitfähige Wärmekopplungsanordnung (4) ein wärmeleitendes Wärmekopplungselement (9) aus Kupfer enthält, das an der aktiven Fläche des Chips anliegt.

9. Die Halbleitereinheit nach einem der Ansprüche 1-8, wobei der Hitzeverteiler (3) in dem Flächenbereich, der mit der thermisch leitfähigen Wärmekopplungsanordnung (4) in Anlage ist, mindestens eine Vertiefung aufweist, und
wobei das flexible Wärmekopplungselement (5) an dem vertieften Hitzeverteilerflächenbereich anliegt.

10. Die Halbleitereinheit nach einem der Ansprüche 1-9, wobei die thermisch leitfähige Wärmekopplungsanordnung (4) ein Wärmekopplungselement (9) enthält, das in dem Flächenbereich, der mit dem flexiblen Wärmekopplungselement (5) in Anlage ist, mindestens eine Vertiefung aufweist.

11. Die Halbleitereinheit nach einem der Ansprüche 1-10, wobei die thermisch leitfähige Wärmekopplungsanordnung (4) ein Wärmekopplungselement (9) enthält, das in dem Flächenbereich, der mit dem flexiblen Wärmekopplungselement (5) in Anlage ist, mindestens eine Erhöhung aufweist.

12. Die Halbleitereinheit nach einem der Ansprüche 1-5, wobei das flexible Wärmekopplungselement (5), ein federnder Teil des Hitzeverteilers (3) ist.

13. Die Halbleitereinheit nach Anspruch 12, wobei der federnde Teil (5) des Hitzeverteilers (3) durch eine teilweise freigeschnittene Zunge gebildet ist.

14. Die Halbleitereinheit nach Anspruch 13, wobei die freigeschnittene Zunge (5) in einem Verbindungsbereich zum Hitzeverteiler (3) einen abgewinkelten Bereich aufweist.

15. Die Halbleitereinheit nach einem der Ansprüche 12-14, wobei die thermisch leitfähige Wärmekopplungsanordnung (4) ein Wärmekopplungselement (9) aus Kupfer aufweist, das zwischen der aktiven Fläche des Chips (2) und dem federnden Teil des Hitzeverteilers (5) angebracht ist.

16. Die Halbleitereinheit nach einem der Ansprüche 12-14, wobei die thermisch leitfähige Wärmekopplungsanordnung (4) ein elastisches Wärmekopplungselement (10) aufweist, das an dem federnden Teil (5) des Hitzeverteilers anliegt.

17. Die Halbleitereinheit nach Anspruch 15, wobei der federnde Teil (5) des Hitzeverteilers (3) in dem Flächenbereich, der mit dem elastischen Wärmekopplungselement (10) in Anlage ist, mindestens eine Vertiefung aufweist.
